# EUROPEAN PATENT APPLICATION

(11) **EP 3 385 938 A1**
(43) Date of publication of application: **10.10.2018**
(21) Application number: 16870206.6
(22) Date of filing: 30.11.2016
(51) Int. Cl.: G09F 9/00, G02F 1/1345, G02F 1/1368, G02F 1/167, G09F 9/30

(54) **DISPLAY DEVICE AND METHOD FOR PRODUCING DISPLAY DEVICE**

(30) Priority: 03.12.2015 JP 2015236733
(71) Applicant: Toppan Printing Co., Ltd., Tokyo 110-0016 (JP)
(72) Inventor: EMORI, Akira, 110-0016 Tokyo (JP)
(74) Representative: Cabinet Plasseraud
(86) International application number: PCT/JP2016/005031
(87) International publication number: WO 2017/094265

(57) **Abstract**

Provided is a display device in which a driver IC can be mounted without increasing the machine cost and the manufacturing cost, and also provided is a method for producing the display device. The display device includes a base material, a thin-film transistor layer formed on a first surface of the base material, a display layer formed on the thin-film transistor layer so as to cover the thin-film transistor layer, a first barrier film having an area larger than the display layer and laminated on the display layer and the base material so as to cover the display layer, and driver-mounting electrodes formed on the first surface of the base material; wherein the first barrier film surrounds at least two sides of the periphery of each group of driver-mounting electrodes in plan view.

## Description

### [Technical Field]

The present invention relates to a display device and a method for producing the display device.

### [Background Art]

Electronic displays have been increasingly used where price tags, shipping tags, signboards, and similar display media with printed materials, such as paper, are conventionally used, due to the use of, as display devices, electronic paper having a light weight, a thin shape, and low power consumption, and characteristically providing a highly-readable display. Flexible display devices have recently been put into practical use in which active elements, such as thin-film transistors (TFTs), are formed on flexible plastic base materials, and such display devices are used to display price tags mentioned above.

When TFTs are formed on plastic base materials, the thickness of each layer and overlapping accuracy have a large impact on the switching performance of the TFTs; therefore, in a general method, a base material containing polyimide, which has relatively high heat resistance, is formed on a substrate that is smooth and has high dimensional stability, such as glass, to obtain a base material, or a polyimide film is bonded to a glass substrate to obtain a base material, followed by peeling from the glass substrate after a TFT layer is formed, thereby obtaining a flexible TFT substrate.

It is necessary to use ICs, such as source drivers and gate drivers, to drive TFT substrates, and a tape carrier package (TCP), which is a circuit board mounted with a driver IC, is connected through an anisotropic conductive film (ACF) for use.

For the purpose of cost reduction by downsizing the component mounting portion, i.e., "frame," around the display section, or by reducing the number of members used, a method for directly mounting a driver IC on a plastic base material on which the TFT is formed (when the base material is glass, a general mounting method known as Chip On Glass (COG)) was examined; however, when the plastic base material is removed from the glass substrate, the thin thickness of the base material makes it difficult to accurately mount the driver IC due to curls, wrinkles, etc.

Moreover, in a state where a plastic base material is laminated on a glass substrate, in the case of multiple surface mounting production (simultaneously producing a plurality of display devices on one base material), for example, when a 400-mm square glass substrate is used, the mounting part of a display device surface-mounted on the center is 200 mm apart from the edge of the substrate, and a large and complicated mounting machine is required, which results in an increase in the machine cost. Furthermore, when the entire glass substrate is cut to the size of the display device, a general mounting device can be used; however, the glass substrate can be used only once, which leads to an increase in the manufacturing cost.

### [Citation List]

### [Patent Literature]

[PTL 1] JP 2015-129830 A

### [Summary of the Invention]

### [Technical Problem]

The present invention has been made in consideration of the above circumstances; and the present invention provides a display device in which a driver IC can be mounted on a plastic base material without increasing the machine cost and the manufacturing cost, and also provides a method for producing the display device.

### [Solution to Problem]

One aspect of the present invention for solving the above problems is a display device including: a base material, a thin-film transistor layer formed on a first surface of the base material, a display layer formed on the thin-film transistor layer so as to cover the thin-film transistor layer, a first barrier film having an area larger than the display layer and laminated on the display layer and the base material so as to cover the display layer, and driver-mounting electrodes formed on the first surface of the base material; wherein the first barrier film surrounds at least two sides of the periphery of each group of driver-mounting electrodes in plan view.

Moreover, the display device may further include a second barrier film formed on a second surface of the base material in a position at least overlapping the entire display layer in plan view.

Furthermore, the first barrier film and the second barrier film may have a part in which the first barrier film and the second barrier film are directly bonded to each other on the outside of peripheral sides of the base material in which sides the driver-mounting electrodes are not formed.

Another aspect of the present invention is a method for producing a display device, the method including: a step of forming a first laminated body on a glass substrate by laminating a base material on the glass substrate, forming a plurality of surfaces each containing a combination of driver-mounting electrodes and a thin-film transistor region on a surface of the base material, laminating a display layer on each of the thin-film transistor regions, and laminating a first barrier film laminated body having an area larger than the display layers on the base material and the display layers so as to cover the display layers, the first barrier film laminated body having openings in parts in which the driver-mounting electrodes are formed; a step of forming a second laminated body by peeling the first laminated body from the glass substrate, and laminating a second barrier film on a surface of the first laminated body on which the first barrier film laminated body is not laminated, the second barrier film having openings in parts opposite to the driver-mounting electrodes; and a step of cutting the second laminated body so that the second laminated body is separated for each surface, and mounting a driver IC on each surface.

Still another aspect of the present invention is a method for producing a display device, the method including: a step of forming a third laminated body by laminating a base material on a glass substrate, forming a plurality of surfaces each containing a combination of driver-mounting electrodes and a thin-film transistor region on a surface of the base material, laminating a display layer on each of the thin-film transistor regions, cutting the base material at portions between the laid out surfaces, and peeling and removing the cut portions between the laid out surfaces, thereby forming the third laminated body in which the base materials, each having the driver-mounting electrodes formed thereon and the thin-film transistor region and the display layer laminated thereon, are arranged in the form of a plurality of islands on the glass substrate; a step of forming a fourth laminated body on the glass substrate by laminating a first barrier film laminated body having an area larger than the display layers so as to cover the display layers, the first barrier film laminated body having openings corresponding to parts in which the driver-mounting electrodes are formed on the surface of the base material of the third laminated body; a step of forming a fifth laminated body by peeling the fourth laminated body from the glass substrate, and laminating a second barrier film on a surface of the fourth laminated body on which the first barrier film laminated body is not laminated, the second barrier film having openings in positions opposite to the driver-mounting electrodes; and a step of cutting the fifth laminated body so that the fifth laminated body is separated for each surface, and mounting a driver IC on each surface.

Moreover, the first barrier film laminated body may be obtained by peeling a third protective film from a laminated body in which a first protective film, a second protective film, a first barrier film, a thermoplastic adhesive layer, and the third protective film are peelably laminated in this order, and in which the relationship among adhesion strength A between the first protective film and the second protective film, adhesion strength B between the second protective film and the barrier film, and adhesion strength C between the thermoplastic adhesive layer and the third protective film satisfies C<A<B; and the first barrier film laminated body may be bonded to the display layers via the thermoplastic adhesive layer.

Furthermore, as the first barrier film laminated body, the second protective film, the first barrier film, the thermoplastic adhesive layer, and the third protective film may be surface-mounted on the first protective film, each having an area larger than each display layer, in the form of separated islands in positions facing the display layers.

### [Advantageous Effects of the Invention]

The present invention can provide a display device in which a driver IC can be mounted on a plastic base material without increasing the machine cost and the manufacturing cost, and can also provide a method for producing the display device.

### [Brief Description of the Drawings]

Fig. 1A shows a plan view and a cross-sectional view of a display device according to one embodiment of the present invention.
Fig. 1B shows a plan view and a cross-sectional view of the display device according to one embodiment of the present invention.
Fig. 1C shows a plan view and a cross-sectional view of the display device according to one embodiment of the present invention.
Fig. 2A shows a plan view and a cross-sectional view of a display device according to one embodiment of the present invention.
Fig. 2B shows a plan view and a cross-sectional view of the display device according to one embodiment of the present invention.
Fig. 2C shows a plan view and a cross-sectional view of the display device according to one embodiment of the present invention.
Fig. 3A shows a plan view and a cross-sectional view of a display device according to one embodiment of the present invention.
Fig. 3B shows a plan view and a cross-sectional view of the display device according to one embodiment of the present invention.
Fig. 3C shows a plan view and a cross-sectional view of the display device according to one embodiment of the present invention.
Fig. 4A shows a plan view and a cross-sectional view of a display device according to one embodiment of the present invention.
Fig. 4B shows a plan view and a cross-sectional view of the display device according to one embodiment of the present invention.
Fig. 5A shows a cross-sectional view that explains a method for producing a display device according to one embodiment of the present invention.
Fig. 5B shows a cross-sectional view that explains the method for producing a display device according to one embodiment of the present invention.
Fig. 5C shows a cross-sectional view that explains the method for producing a display device according to one embodiment of the present invention.
Fig. 5D shows a cross-sectional view that explains the method for producing a display device according to one embodiment of the present invention.
Fig. 5E shows a cross-sectional view that explains the method for producing a display device according to one embodiment of the present invention.
Fig. 6A shows a cross-sectional view that explains a method for producing a display device according to one embodiment of the present invention.
Fig. 6B shows a cross-sectional view that explains the method for producing a display device according to one embodiment of the present invention.
Fig. 6C shows a cross-sectional view that explains the method for producing a display device according to one embodiment of the present invention.
Fig. 6D shows a cross-sectional view that explains the method for producing a display device according to one embodiment of the present invention.
Fig. 6E shows a cross-sectional view that explains the method for producing a display device according to one embodiment of the present invention.
Fig. 7 shows a cross-sectional view of a barrier film laminated body used in a production method according to one embodiment of the present invention.
Fig. 8A shows a plan view of a barrier film laminated body used in a production method according to one embodiment of the present invention.
Fig. 8B shows a plan view of the barrier film laminated body used in a production method according to one embodiment of the present invention.

### [Description of Embodiments]

The following describes, with reference to the attached drawings, a display device in which the rigidity of a base material in the vicinity of driver-mounting electrodes is increased by a barrier film, and a method for producing the display device, according to embodiments of the present invention.

### (Display Device)

### (First Embodiment)

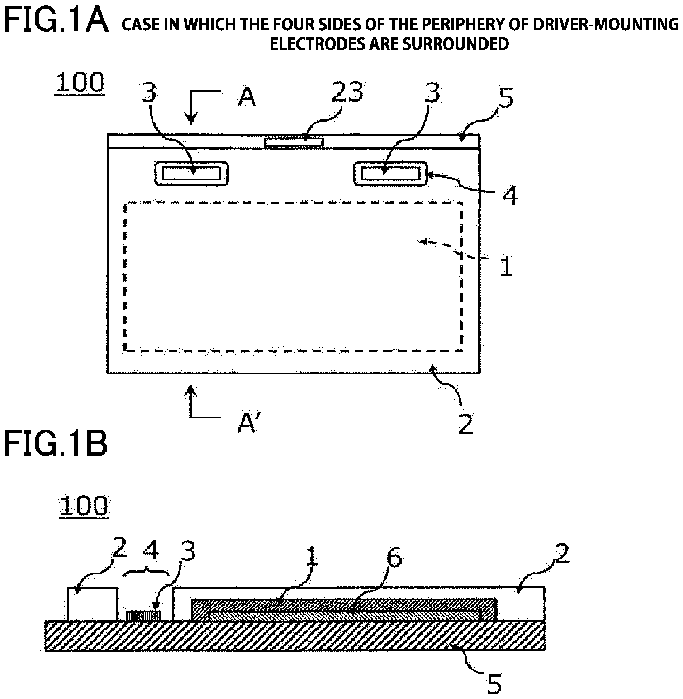

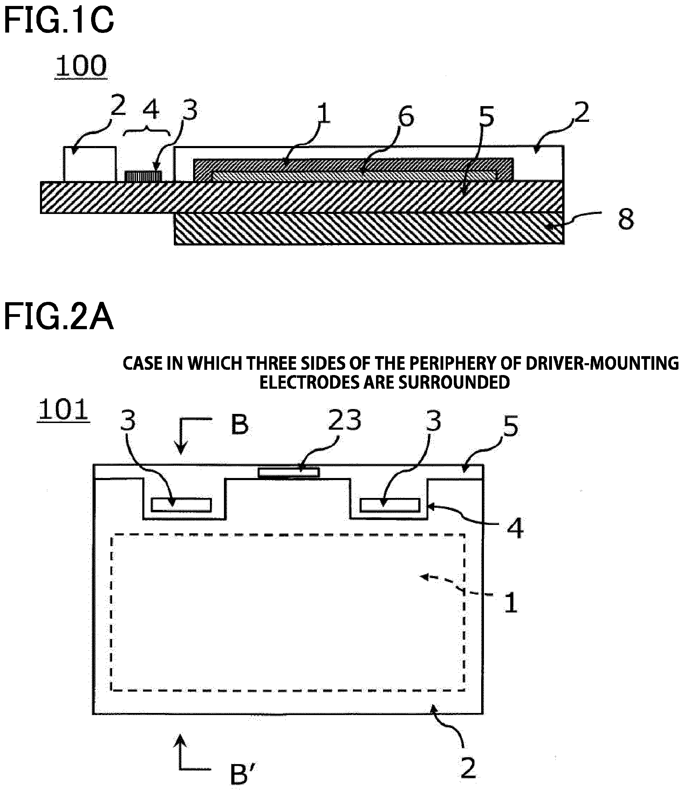

Fig. 1A is a plan view schematically showing a display device 100 according to a first embodiment of the present invention, in which a first barrier film 2 surrounds the four sides of the periphery of each group of driver-mounting electrodes 3; Fig. 1B is a cross-sectional view taken along the line A-A' of Fig. 1A; and Fig. 1C shows a modified example of the display device 100.

Here, the driver-mounting electrodes 3 refer to an electrode group provided on a base material 5 to be connected with a plurality of input/output electrode pads of a driver IC.

As shown in Fig. 1A, the display device 100 includes the first barrier film 2 having an area larger than a display layer 1 and covering the display layer 1, in plan view, and the first barrier film 2 has a shape surrounding the four sides of the outer periphery of each group of driver-mounting electrodes 3 on the surface of the base material 5 (i.e., a shape having openings so as not to cover the driver-mounting electrodes 3).

As shown in Fig. 1B, the display device 100 includes a thin-film transistor region 6 on a first surface of the base material 5, the display layer 1 covering the thin-film transistor region 6, the driver-mounting electrodes 3 on the same surface of the base material 5 on which the thin-film transistor region 6 is formed, and the first barrier film 2 that has openings 4 so as not to cover the driver-mounting electrodes 3 and that is laminated so as to cover the display layer 1.

If barrier properties are required for the surface (back surface) of the base material 5 on which the thin-film transistor region 6 is not formed, a second barrier film 8 having an area larger than the display layer 1 is laminated on the back surface, as shown in Fig. 1C.

### (Second Embodiment)

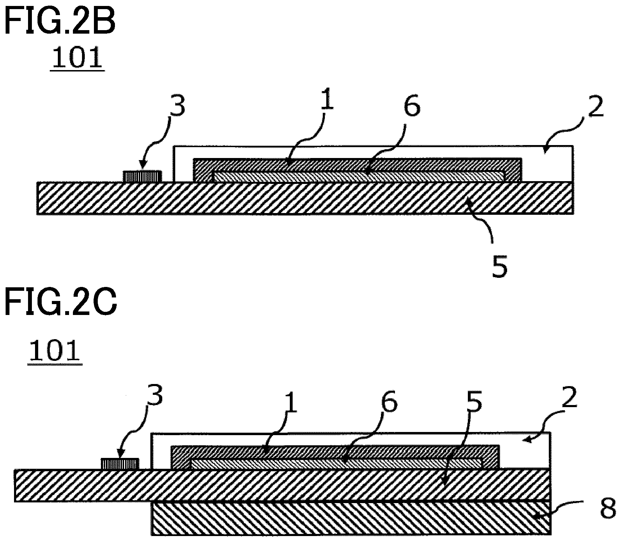

Fig. 2A is a plan view schematically showing a display device 101 according to a second embodiment of the present invention, in which a first barrier film 2 surrounds three sides of the periphery of each group of driver-mounting electrodes 3; Fig. 2B is a cross-sectional view taken along the line B-B' of Fig. 2A; and Fig. 2C shows a modified example of the display device 101.

As shown in Fig. 2A, the display device 101 includes the first barrier film 2 having an area larger than a display layer 1 and covering the display layer 1 in plan view, and the first barrier film 2 has a shape surrounding three sides of the outer periphery of each group of driver-mounting electrodes 3, other than a side (on the driver input side) far from the display surface, on the surface of the base material 5; that is, the first barrier film 2 has a shape in which the three sides of the outer periphery of each group of driver-mounting electrodes 3 face the first barrier film 2.

As shown in Fig. 2B, the display device 101 includes a thin-film transistor region 6 on a first surface of the base material 5, the display layer 1 covering the thin-film transistor region 6, the driver-mounting electrodes 3 on the same surface of the base material 5 on which the thin-film transistor region 6 is formed, and the first barrier film 2 that has a missing area so as not to cover the driver-mounting electrodes 3 and that is laminated so as to cover the display layer 1.

If barrier properties are required for the surface (back surface) of the base material 5 on which the thin-film transistor region 6 is not formed, a second barrier film 8 having an area larger than the display layer 1 is laminated on the back surface, as shown in Fig. 2C.

### (Third Embodiment)

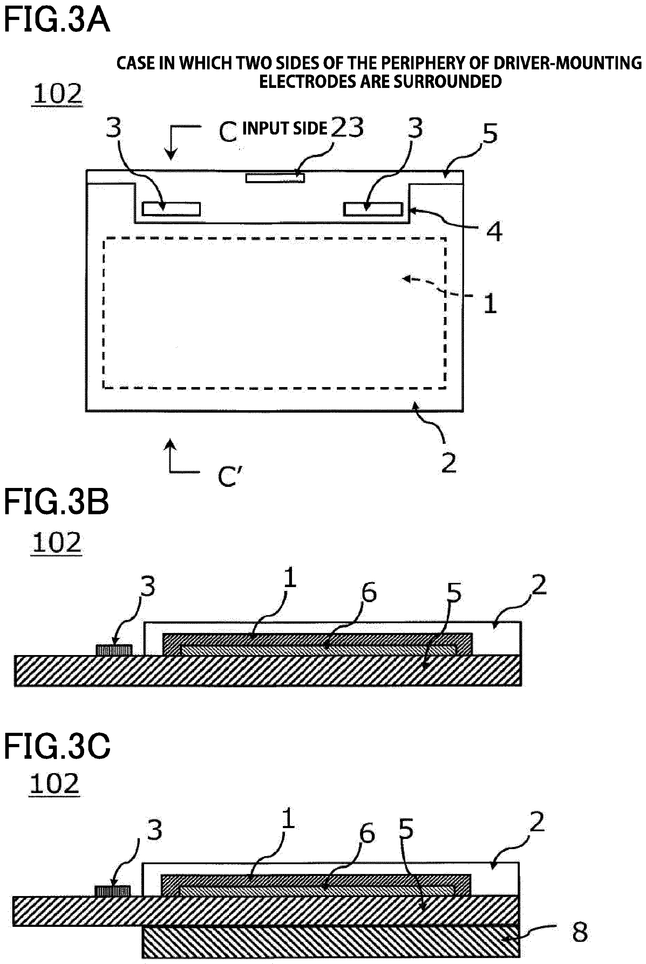

Fig. 3A is a plan view schematically showing a display device 102 according to a third embodiment of the present invention, in which a first barrier film 2 surrounds two sides of the periphery of each group of driver-mounting electrodes 3; Fig. 3B is a cross-sectional view taken along the line C-C' of Fig. 3A; and Fig. 3C shows a modified example of the display device 102.

As shown in Fig. 3A, the display device 102 includes the first barrier film 2 having an area larger than a display layer 1 and covering the display layer 1 in plan view, and the first barrier film 2 has a shape surrounding two sides of the outer periphery of each group of driver-mounting electrodes 3, other than a side (on the driver input side) far from the display layer and a side orthogonal to this side and positioned in the inside of the display device, on the surface of the base material 5.

As shown in Fig. 3B, the display device 102 includes a thin-film transistor region 6 on a first surface of the base material 5, the display layer 1 covering the thin-film transistor region 6, the driver-mounting electrodes 3 on the same surface of the base material 5 on which the thin-film transistor region 6 is formed, and the first barrier film 2 that has a missing area so as not to cover the driver-mounting electrodes 3 and that is laminated so as to cover the display layer 1.

If barrier properties are required for the surface (back surface) of the base material 5 on which the thin-film transistor region 6 is not formed, a second barrier film 8 having an area larger than the display layer 1 is laminated on the back surface, as shown in Fig. 3C.

The base material 5 used in each embodiment is a flexible film base material, and usable examples thereof include films using plastic materials or clay materials, such as polyethylene terephthalate (PET), polyethylene naphthalate (PEN), polyimide, polyether sulfone (PES), polycarbonate, etc.; particularly, in consideration of film deformation due to process temperature, the base material 5 is preferably a film having a thickness of 5 µm or more and 30 µm or less and using PEN, polyimide, or a clay material.

Moreover, the first barrier film 2 and the second barrier film 8 have the function to prevent intrusion of oxygen, hydrogen, moisture, etc., from the outside, and to prevent changes in the characteristics of the display layer 1 and the thin-film transistor region 6. The first barrier film 2 laminated on the display layer 1 side has visible-light transmittance, and is formed from a thin film of an inorganic material, such as aluminum oxide (Al₂O₃), silicon oxide (SiO₂), silicon nitride (SiNx), silicon oxynitride (SiON), or the like. In contrast, metal foil, such as aluminum, can also be used for the second barrier film 8, for which visible-light transmittance is not essential.

### (Fourth Embodiment)

The following describes, with reference to the attached drawings, a display device 103 according to a fourth embodiment of the present invention, the display device 103 having a part in which a first barrier film 2 and a second barrier film 8 are directly bonded without interposing a base material 5 on a side of the outer periphery of the base material 5 on which driver-mounting electrodes 3 are not formed, whereby the barrier properties against intrusion of moisture from the outer periphery are increased.

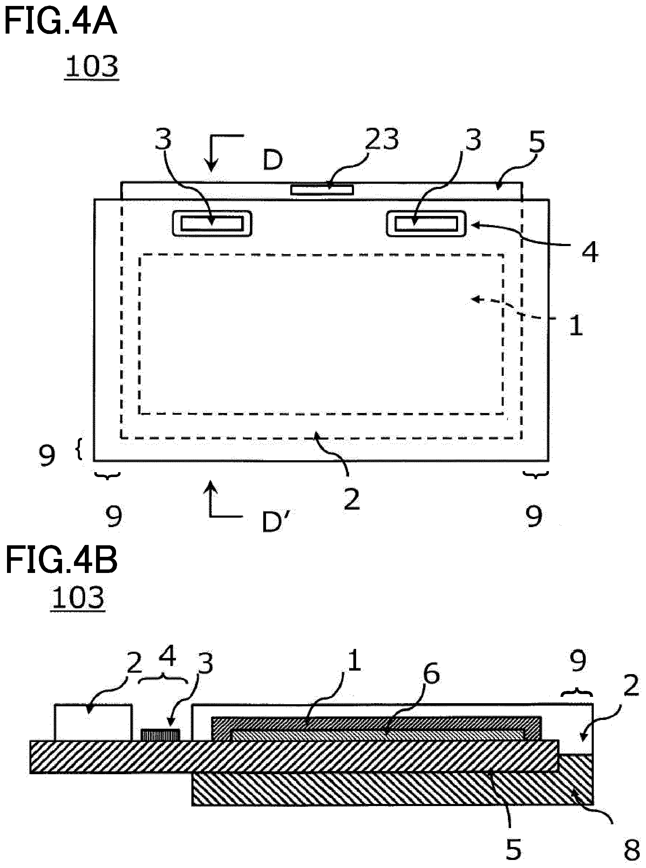

Fig. 4A is a plan view schematically showing the display device 103, and Fig. 4B shows a cross-sectional view taken along the line D-D' of Fig. 4A.

As shown in Fig. 4A, the display device 103 includes the first barrier film 2 having an area larger than a display layer 1 and covering the display layer 1 in plan view, and the first barrier film 2 has a shape surrounding the four sides of the outer periphery of each group of driver-mounting electrodes 3 on the surface of the base material 5 (i.e., a shape having openings so as not to cover the driver-mounting electrodes 3).

As shown in Fig. 4B, the display device 103 includes a thin-film transistor region 6 on a first surface of the base material 5, the display layer 1 covering the thin-film transistor region 6, the driver-mounting electrodes 3 adjacent to one side of the base material 5 and provided on the same surface of the base material 5 on which the thin-film transistor region 6 is formed, and the first barrier film 2 that has openings 4 so as not to cover the driver-mounting electrodes 3 and that is laminated so as to cover the display layer 1.

The second barrier film 8 having an area larger than the display layer 1 is laminated on the surface (back surface) of the base material 5 on which the thin-film transistor region 6 is not formed, as shown in Fig. 4B.

Moreover, the three sides of the base material 5, on which the driver-mounting electrodes 3 are not formed, have a part 9 in which the first barrier film 2 and the second barrier film 8 extend from the outer edge of the base material 5 and are directly bonded.

The above structure strengthens the adhesion between the first barrier film 2 and the second barrier film 8, and increases the resistance to intrusion of oxygen and moisture from the outer periphery; thus, a highly-reliable display device can be obtained.

### (Method for Producing Display Device)

### (Fifth Embodiment)

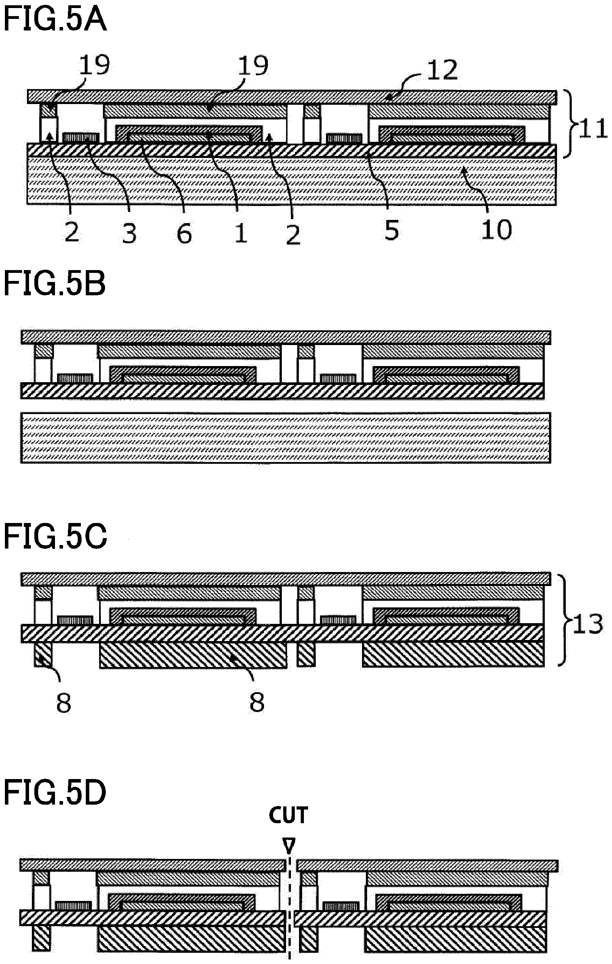

The following describes a method for producing a display device according to a fifth embodiment of the present invention, with reference to the attached drawings. Figs. 5A to 5E are cross-sectional views that explain the method for producing a display device according to the embodiment of the present invention.

First, a base material 5 is laminated on a glass substrate 10 by applying a solution of a flexible material, such as PEN, polyimide, or a clay material, to the glass substrate 10, and drying the applied solution, or by bonding such a material formed in a film shape to the glass substrate 10. Further, a plurality of surfaces each containing a thin-film transistor region 6, driver-mounting electrodes 3, a wiring electrode, etc., are formed on the surface of the base material 5 by various printing methods, such as flexographic printing, offset printing, screen printing, and ink-jet printing, as well as photolithography.

Next, a display layer 1 whose coloring state changes upon application of voltage is laminated on the surface of each thin-film transistor region 6, a first barrier film 2 having an area larger than the display layers 1 is laminated so as to cover the display layers 1, a second protective film 19 is laminated so as to cover the first barrier film 2, and a first protective film 12 is laminated so as to cover the second protective film 19 and the driver-mounting electrodes 3; thus, a first laminated body 11 is formed on the glass substrate 10 (Fig. 5A). In this step, a barrier film laminated body 22, described later, may be used.

In this case, because the first protective film 12 is larger than the first barrier film 2 and covers the driver-mounting electrodes 3, the driver-mounting electrodes 3 can be prevented from contamination during bonding by a roll laminator or the like, due to the adhesive of the first barrier film 2, etc., transferred from the end portion of the barrier film to the laminate roll.

Next, the first laminated body 11 is peeled from the glass substrate 10 (Fig. 5B), and a second barrier film 8 is bonded to the surface of the first laminated body 11 on which the thin-film transistor regions 6 are not formed, thereby forming a second laminated body 13 (Fig. 5C).

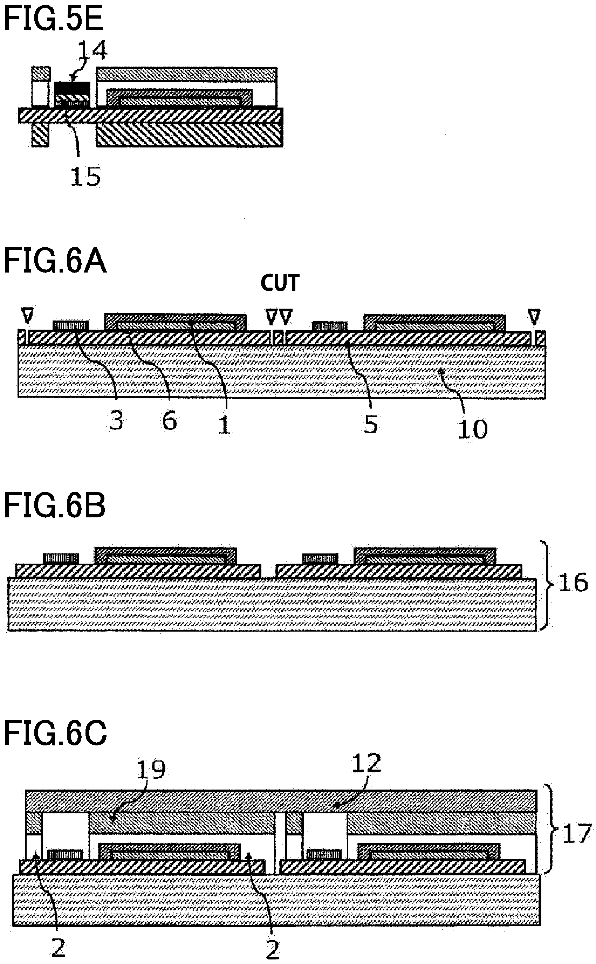

Next, the second laminated body 13 is cut into pieces (Fig. 5D) so that each piece contains one display layer 1, and a driver IC 14 is bonded on each group of driver-mounting electrodes 3 using an ACF 15 (Fig. 5E).

### (Sixth Embodiment)

The following describes a method for producing a display device according to a sixth embodiment of the present invention, with reference to the attached drawings. Figs. 6A to 6E are cross-sectional views that explain the method for producing a display device according to the embodiment of the present invention.

First, a base material 5 is laminated on a glass substrate 10 by applying a solution of a flexible material, such as PEN, polyimide, or a clay material, to the glass substrate 10, and drying the applied solution, or by bonding such a material formed in a film shape to the glass substrate 10. Further, a plurality of surfaces each containing a thin-film transistor region 6, driver-mounting electrodes 3, a wiring electrode, etc., are formed on the surface of the base material 5 by various printing methods, such as flexographic printing, offset printing, screen printing, and ink-jet printing, as well as photolithography.

Next, a display layer 1 whose coloring state changes upon application of voltage is laminated on the surface of each thin-film transistor region 6; subsequently, the base material 5 is cut into pieces on the glass substrate 10 so that each piece contains at least one display layer 1 and the driver-mounting electrodes 3; then, portions of the surface of the base material 5 that do not contain the display layers 1 are peeled and removed from the glass substrate 10; and thus, a third laminated body 16 is formed (Figs. 6A and 6B).

Next, a first barrier film 2 is laminated so as to cover the display layers 5, and further to reach the glass substrate 10 that has been exposed by peeling and removing the base material 5 on three sides on which the driver-mounting electrodes 3 are not formed in plan view, a second protective film 19 is laminated so as to cover the first barrier film 2, and a first protective film 12 is laminated so as to cover the second protective film 19 and the driver-mounting electrodes 3; thus, a fourth laminated body 17 is formed (Fig. 6C). In this step, a barrier film laminated body 22, described later, may be used.

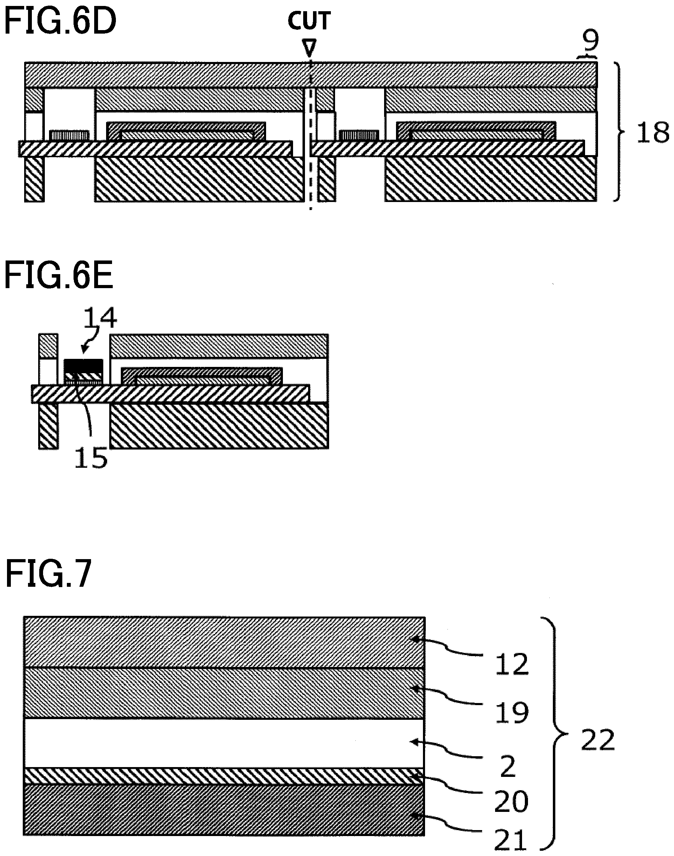

Next, the fourth laminated body 17 is peeled from the glass substrate 10, and a second barrier film 8 is bonded to the surface of the fourth laminated body 17 on which the thin-film transistor regions 6 are not formed; thus, a fifth laminated body 18 is formed (Fig. 6D). The structure in this case is such that a part 9 in which the first barrier film 2 and the second barrier film 8 are directly bonded is present on the three sides on which the driver-mounting electrodes 3 are not formed.

Next, the fifth laminated body 18 is cut into pieces so that each piece contains one display layer 1 (Fig. 6E), and a driver IC 14 is bonded on each group of driver-mounting electrodes 3 using an ACF 15.

### (Barrier Film Laminated Body)

The following describes a barrier film laminated body 22 used in a method for producing a display device according to an embodiment of the present invention, with reference to the attached drawings.

Fig. 7 is a cross-sectional view schematically showing the laminated structure of the barrier film laminated body 22 used in a method for producing a display device according to one embodiment of the present invention. In the barrier film laminated body 22, a first protective film 12, a second protective film 19, a first barrier film 2, a thermoplastic adhesive layer 20, and a third protective film 21 are laminated in this order so as to be peelable between each layer.

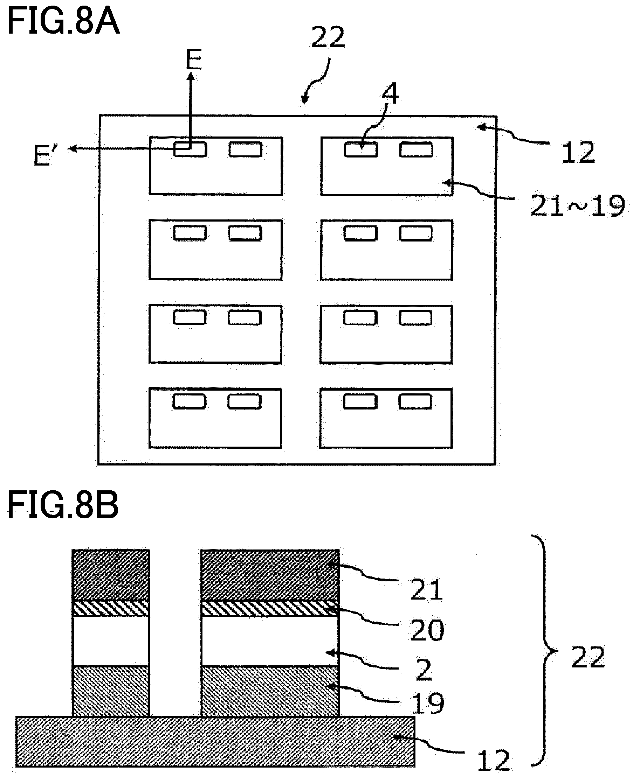

Figs. 8A and 8B schematically show the barrier film laminated body 22 used in a method for producing a display device according to one embodiment of the present invention. Fig. 8A is a plan view as viewed from the third protective film 21 side, and Fig. 8B is a cross-sectional view taken along the line E-E' of Fig. 8A. As shown in Fig. 8A, the second protective film 19, the first barrier film 2, the thermoplastic adhesive layer 20, and the third protective film 21, each of which has openings 4 corresponding to two driver-mounting electrodes, are surface-mounted on the first protective film 12 in the form of a plurality of islands.

Next, how to use the barrier film laminated body 22 is explained. In the above-mentioned method for producing a display device, the barrier film laminated body 22 is used in the step of forming the first barrier film 2, the second protective film 19, and the first protective film 12 on the display layers 1. Specifically, after the display layers 1 are formed, the protective film 21 is peeled from the barrier film laminated body 22 so that the thermoplastic adhesive layer 20 is exposed. Thereafter, the barrier film laminated body 22 is bonded to each display layer 1 while making the thermoplastic adhesive layer 20 face the display layer 1 and adjusting the position of the openings 4 to match the position of the driver-mounting electrodes 3. As a result, the first barrier film 2 can be laminated so as to cover each display layer 1, the second protective film 19 can be laminated so as to cover the first barrier film 2, and the first protective film 12 can be laminated so as to cover the second protective film 19 and the driver-mounting electrodes 3, as shown in Figs. 5A and 6C.

In the barrier film laminated body 22, the relationship among adhesion strength A between the first protective film 12 and the second protective film 19, adhesion strength B between the second protective film 19 and the first barrier film 2, and adhesion strength C between the thermoplastic adhesive layer 20 and the third protective film 21 preferably satisfies C<A<B. Due to this relationship, when the protective film 21 is peeled from the barrier film laminated body 22 in the production process of the display device, the first protective film 12, the second protective film 19, and the first barrier film 2 can be prevented from peeling. Moreover, when the second protective film 19, the first barrier film 2, the thermoplastic adhesive layer 20, and the third protective film 21 are formed in the form of islands on the first protective film 12, or when the openings 4 corresponding to the driver-mounting electrodes 3 are provided, part of the second protective film 19, the first barrier film 2, the thermoplastic adhesive layer 20, and the third protective films 21 can be easily peeled and removed from the barrier film laminated body 22.

Due to the use of the barrier film laminated body 22 described above, when the first barrier film 2 is laminated on the base material 5 on which a plurality of display layers 1 are surface-mounted, plural surfaces can be laminated at once while preventing the driver-mounting electrodes 3 from contamination by the adhesive, etc., transferred from the laminate roll.

### [Examples]

Specific Examples are described below.

### (Example 1)

The display device 100 shown in Figs. 1A and 1B was produced by the steps shown in Figs. 5A to 5E. First, a PEN film was bonded to a glass substrate 10 using a pressure-sensitive adhesive (not shown) to form a base material 5. Next, eight surfaces each containing a thin-film transistor region 6, driver-mounting electrodes 3, and a wiring electrode were formed on the base material 5 using printing methods in combination. Next, a display layer 1 whose coloring state changes upon application of voltage was laminated on the surface of each thin-film transistor region 6.

Next, a barrier film laminated body 22 of the same size as the glass substrate 10 was prepared; as shown in Fig. 8A, a third protective film 21 to a second protective film 19 covered each display layer 1, and the third protective film 21 to the second protective film 19 were half-cut by laser machining into a shape having openings 4 in portions corresponding to the driver-mounting electrodes 3; and then unnecessary parts were peeled and removed.

Next, the third protective film 21 of the barrier film laminated body 22 was peeled, and the barrier film laminated body 22 was bonded onto the display layers 1 (Fig. 5A).

Next, a first laminated body 11 was peeled from the glass substrate 10 (Fig. 5B), and a second barrier film 8 was bonded to the surface of the first laminated body 11 on which the thin-film transistor regions 6 were not formed, thereby forming a second laminated body 13 (Fig. 5C).

Next, the second laminated body 13 was cut into pieces so that each piece contained one display layer 1 (Fig. 5D). Finally, a driver IC 14 was bonded on each group of driver-mounting electrodes 3 using an ACF 15 (Fig. 5E), and then connected to a drive circuit through a flexible printed circuit. The display device was driven, and it was confirmed that the display device displayed normally.

### (Example 2)

The display device 103 shown in Figs. 4A and 4B was produced by the steps shown in Figs. 6A to 6E. First, a PEN film was bonded to a glass substrate 10 using a pressure-sensitive adhesive (not shown) to form a base material 5. Next, eight surfaces each containing a thin-film transistor region 6, driver-mounting electrodes 3, and a wiring electrode were formed on the base material 5 using printing methods in combination. Next, a display layer 1 whose coloring state changes upon application of voltage was laminated on the surface of each thin-film transistor region 6.

Next, a barrier film laminated body 22 of the same size as the glass substrate 10 was prepared; as shown in Figs. 8A and 8B, a third protective film 21 to a second protective film 19 covered each display layer 1, and the third protective film 21 to the second protective film 19 were half-cut by laser machining into a shape having openings 4 in portions corresponding to the driver-mounting electrodes 3; and then unnecessary parts were peeled and removed.

Next, the base material 5 was cut into pieces on the glass substrate 10 so that each piece contained one display layer 1 and one driver-mounting electrodes 3, and then portions of the surface of the base material 5 that did not contain the display layers 1 were peeled and removed from the glass substrate 10 (Fig. 6B).

Next, the third protective film 21 of the barrier film laminated body 22 was peeled, and the barrier film laminated body 22 was bonded onto the display layers 1 (Fig. 6C).

Next, a fourth laminated body 17 was peeled from the glass substrate 10, and a second barrier film 8 was bonded to the surface of the fourth laminated body 17 on which the thin-film transistor regions 6 were not formed, thereby forming a fifth laminated body 18 (Fig. 6D).

Next, the fifth laminated body 18 was cut into pieces so that each piece contained one display layer 1 (Fig. 6D). Finally, a driver IC 14 was bonded on each group of driver-mounting electrodes 3 using an ACF 15 (Fig. 6E), and then connected to a drive circuit through a flexible printed circuit. The display device was driven, and it was confirmed that the display device normally displayed.

As described above, the present invention can produce a display device fabricated on a plastic base material without increasing the device cost and the manufacturing cost.

### [Industrial Applicability]

The present invention is useful for display devices that use thin-film transistors as active elements, such as electronic paper, liquid crystal displays, and organic EL displays.

### [Reference Signs List]

1 ... Display layer
2 ... First barrier film
3 ... Group of driver-mounting electrodes
4 ... Opening
5 ... Base material
6 ... Thin-film transistor region
8 ... Second barrier film
9 ... Directly bonded part
10 ... Glass substrate
11 ... First laminated body
12 ... First protective film
13 ... Second laminated body
14 ... Driver IC
15 ... ACF
16 ... Third laminated body
17 ... Fourth laminated body
18 ... Fifth laminated body
19 ... Second protective film
20 ... Thermoplastic adhesive layer
21 ... Third protective film
22 ... Barrier film laminated body
23 ... Connecting electrodes
100, 101, 102, 103 ... Display device

## Claims

1. A display device comprising:
a base material,
a thin-film transistor layer formed on a first surface of the base material,
a display layer formed on the thin-film transistor layer so as to cover the thin-film transistor layer,
a first barrier film having an area larger than the display layer and laminated on the display layer and the base material so as to cover the display layer, and
driver-mounting electrodes formed on the first surface of the base material;
wherein the first barrier film surrounds at least two sides of the periphery of each group of driver-mounting electrodes in plan view.

2. The display device according to claim 1, further comprising a second barrier film formed on a second surface of the base material in a position at least overlapping the entire display layer in plan view.

3. The display device according to claim 2, wherein the first barrier film and the second barrier film have a part in which the first barrier film and the second barrier film are directly bonded to each other on the outside of peripheral sides of the base material in which sides the driver-mounting electrodes are not formed.

4. A method for producing a display device, the method comprising:
a step of forming a first laminated body on a glass substrate by laminating a base material on the glass substrate, forming a plurality of surfaces each containing a combination of driver-mounting electrodes and a thin-film transistor region on a surface of the base material, laminating a display layer on each of the thin-film transistor regions, and laminating a first barrier film laminated body having an area larger than the display layers on the base material and the display layers so as to cover the display layers, the first barrier film laminated body having openings in parts in which the driver-mounting electrodes are formed;
a step of forming a second laminated body by peeling the first laminated body from the glass substrate, and laminating a second barrier film on a surface of the first laminated body on which the first barrier film laminated body is not laminated, the second barrier film having openings in parts opposite to the driver-mounting electrodes; and
a step of cutting the second laminated body so that the second laminated body is separated for each surface, and mounting a driver IC on each surface.

5. A method for producing a display device, the method comprising:
a step of forming a third laminated body by laminating a base material on a glass substrate, forming a plurality of surfaces each containing a combination of driver-mounting electrodes and a thin-film transistor region on a surface of the base material, laminating a display layer on each of the thin-film transistor regions, cutting the base material at portions between the laid out surfaces, and peeling and removing the cut portions between the laid out surfaces, thereby forming the third laminated body in which the base materials, each comprising the driver-mounting electrodes formed thereon and the thin-film transistor region and the display layer laminated thereon, are arranged in the form of a plurality of islands on the glass substrate;
a step of forming a fourth laminated body on the glass substrate by laminating a first barrier film laminated body having an area larger than the display layers so as to cover the display layers, the first barrier film laminated body having openings corresponding to parts in which the driver-mounting electrodes are formed on the surface of the base material of the third laminated body;
a step of forming a fifth laminated body by peeling the fourth laminated body from the glass substrate, and laminating a second barrier film on a surface of the fourth laminated body on which the first barrier film laminated body is not laminated, the second barrier film having openings in positions opposite to the driver-mounting electrodes; and
a step of cutting the fifth laminated body so that the fifth laminated body is separated for each surface, and mounting a driver IC on each surface.

6. The method for producing a display device according to claim 4 or 5, wherein the first barrier film laminated body is obtained by peeling a third protective film from a laminated body in which a first protective film, a second protective film, a first barrier film, a thermoplastic adhesive layer, and the third protective film are peelably laminated in this order, and in which the relationship among adhesion strength A between the first protective film and the second protective film, adhesion strength B between the second protective film and the barrier film, and adhesion strength C between the thermoplastic adhesive layer and the third protective film satisfies C<A<B; and the first barrier film laminated body is bonded to the display layers via the thermoplastic adhesive layer.

7. The method for producing a display device according to claim 6, wherein as the first barrier film laminated body, the second protective film, the first barrier film, the thermoplastic adhesive layer, and the third protective film are surface-mounted on the first protective film, each having an area larger than each display layer, in the form of separated islands in positions facing the display layers.
